# EUROPEAN PATENT SPECIFICATION

(11) **EP 3 027 306 B1**
(45) Date of publication and mention of the grant of the patent: **08.12.2021**
(21) Application number: 14749988.3
(22) Date of filing: 01.08.2014
(51) Int. Cl.: B01J 20/04, B01J 20/06, B01J 20/18, B01J 20/30, C01B 3/00, H01J 7/18, H01L 23/26, B01J 20/10, B01D 53/02

(54) **METHOD TO GETTER HYDROGEN AND MOISTURE**
VERFAHREN ZUM GETTERN VON WASSERSTOFF UND FEUCHTIGKEIT
MÉTHODE DE CAPTURE D'HYDROGENE ET DE VAPEUR D'EAU

(30) Priority: 02.08.2013 GB 201313850
(43) Date of publication of application: 08.06.2016
(73) Proprietor: Johnson Matthey Public Limited Company, London EC4A 4AB (GB)
(72) Inventor: CATCHPOLE, Stephen John, Middlesbrough Cleveland TS5 5QJ (GB); DAVIS, David Jonathan, Darlington Durham DL2 2SW (GB); LOCKEY, Katy Anna, Billingham Cleveland TS23 1LB (GB); SMITH, Thomas Luke, Hartlepool County Durham TS24 7PT (GB); TWEDDLE, Jennifer Jane, Hartlepool County Durham TS26 9QY (GB)
(74) Representative: Bown, Mark Richard
(86) International application number: PCT/GB2014/052373
(87) International publication number: WO 2015/015221

(56) References cited:
- EP-A1- 2 517 789
- EP-A2- 0 757 920
- WO-A1-2006/064289
- WO-A1-2013/098734
- US-A1- 2011 272 328
- VASILIJE MANOVIC ET AL: "Core-in-Shell CaO/CuO-Based Composite for CO 2 Capture", INDUSTRIAL & ENGINEERING CHEMISTRY RESEARCH, vol. 50, no. 22, 16 November 2011 (2011-11-16), pages 12384-12391, XP055539343, ISSN: 0888-5885, DOI: 10.1021/ie201427g
- CHANGLEI QIN ET AL: "Enhancing the performance of CaO/CuO based composite for CO2 capture in a combined Ca-Cu chemical looping process", CHEMICAL ENGINEERING JOURNAL, vol. 228, 16 March 2013 (2013-03-16), pages 75-86, XP055539346, ISSN: 1385-8947, DOI: 10.1016/j.cej.2013.04.115

## Description

The present invention relates to a method of gettering hydrogen and moisture using a getter composition.

Getters are adsorbent compositions often used within a sealed enclosure forming part of, or a housing for, the electrical or electronic device, to remove unwanted materials from the atmosphere within the enclosure. Getter compositions for the removal of hydrogen are already known. For example, unsaturated organic compounds may be used as hydrogen getters, optionally in a composition including a hydrogenation catalyst. In US-B-6428612, a hydrogen getter is described comprising a particulate zeolite having a portion of its sodium ions exchanged by an activated metal such as silver. The getter is provided in a flexible hydrogen permeable, moisture-impermeable sheet material in combination with a moisture absorber. US-A-5888925 describes a getter comprising effective amounts of an oxide of a platinum group metal, a desiccant, and a gas permeable binder which preferably is cured after composition in an oxygen-bearing environment at about 150 to about 205 degrees centigrade. A combination of palladium oxide, a molecular sieve desiccant and a silicone binder is the preferred getter composition. US-A-4559471 describes the use of getter auxiliary means for decomposition of hydrocarbons within evacuated apparatus in which the getter auxiliary means comprises an inorganic porous carrier charged with one or more of rhodium, copper, platinum, palladium and their oxides. US-B-6200494 describes a combination of getter materials comprising a mixture of an oxide of a transition metal, metallic palladium and a moisture absorbing material. WO2006064289 describes getter compositions suitable for gettering hydrogen comprising a first metal oxide and a second metal oxide, said first metal oxide being more readily reducible in hydrogen at temperatures between 0 °C and 100 °C than said second metal oxide. The first metal oxide is of a metal selected from platinum, palladium, rhodium and ruthenium. Getters for moisture are also well known. WO02/43098 describes a getter for use in a sealed enclosure, in the form of a porous body formed from particles of a FAU zeolite having a silica to alumina molar ratio below 10 and particles of a high silica to alumina molar ratio zeolite, having a silica to alumina molar ratio of at least 20, bound together with an inorganic binder. V. Manovic et al, in Industrial & Engineering Chemistry Research, Vol. 50, No. 22, p12384-12391 (2011) and Q. Changlei et al, in Chemical Engineering Journal, Vol 22 p75-86 (2013), each disclose CaO/CuO composites for CO₂ capture.

Whilst the getter compositions of the prior art are useful in many applications, the problem of gettering moisture and hydrogen at elevated temperatures provides particular challenges. Some applications require gettering of water, hydrogen and other gases at higher operating temperatures, for example greater than about 80 °C, especially at least 150°C. The problem may be exacerbated in gettering gases from enclosures housing electrical equipment because outgassing of hydrogen, moisture and other gases is increased. Many conventional moisture getters such as zeolites start to desorb water rapidly above about 80 °C and so they are unsuitable for use at such a temperature. Hydrogen getters based on palladium oxide are useful at room temperature and above, but the capacity of palladium metal to absorb hydrogen decreases at higher temperatures. WO2013/098734 describes a combination of getter materials comprising a mixture of cerium oxide, copper oxide and metallic palladium for the removal of hydrogen and carbon monoxide from vacuum panels. The gettering capacity for hydrogen of this combination shows a marked decline at 100 °C compared with the performance at room temperature.

It is therefore an object of the invention to provide a getter composition which is suitable for use at temperatures above 80 °C.

We provide, according to the invention, a method of gettering hydrogen and moisture from a sealed enclosure at a temperature in the range 80-500 °C comprising the step of introducing into said enclosure a getter composition comprising calcium oxide and copper oxide and wherein the getter composition is essentially free of palladium or a palladium compound.

The alkaline earth metal oxide in the getter composition is calcium oxide. A suitable precursor to the alkaline earth metal oxide comprises any alkaline earth metal compound which is converted to calcium oxide by the action of heat. Such compounds include carbonates and hydroxides. The amount of alkaline earth metal oxide in the getter composition may be in the range from 5 - 95 % by weight of the getter composition. The amount of alkaline earth metal oxide in the getter composition may be in the range from 50 - 95 % by weight, especially 60 - 90 % by weight, for example 60 - 80% by weight.

The transition metal oxide in the getter composition is copper oxide. The amount of transition metal oxide in the getter composition may be in the range from 5 - 95 % by weight of the getter composition. The amount of transition metal oxide in the getter composition may be in the range from 5 - 60% by weight, particularly 5 - 50% by weight, especially 10 - 40 % by weight, for example 10 - 30% by weight. In some embodiments the amount of transition metal oxide in the getter composition is 20 - 40% by weight. The percentages are given as weight % of the active components, i.e. as a percentage of the total weight of the transition metal oxide plus the alkaline earth metal oxide.

In an embodiment, the getter composition comprises particles of calcium oxide and particles of copper oxide. In another embodiment, the getter composition consists essentially of calcium oxide or a precursor thereof, copper oxide or a precursor thereof and optionally one or more components selected from the group consisting of a pore-forming compound, a binder and a lubricant. In contrast to WO2013/098734, the getter compositions of the invention are essentially free of palladium compounds which we have found are not required for the purposes of gettering hydrogen and moisture at temperatures above 80 °C.

Calcium oxide is known both as a moisture getter and carbon dioxide getter. Calcium oxide reacts with ambient water to form calcium hydroxide at temperatures up to about 500 °C. Calcium oxide also reacts with carbon dioxide to form calcium carbonate.

CaO + H₂O ⇄ Ca(OH)₂

CaO + CO₂ ⇄ CaCO₃

At higher temperatures, the equilibrium between calcium hydroxide and calcium oxide favours dehydration at a partial pressure of about 1 atmosphere. Therefore in order to produce a getter composition containing a very high proportion of calcium oxide, it is necessary to activate the getter composition at a temperature above 500 °C. If getter formulation and forming is carried out at lower temperatures, in contact with a normal room atmosphere then the calcium oxide is likely to contain a substantial amount of calcium hydroxide, due to reaction with water, and calcium carbonate, due to reaction with CO₂. We have found that if a getter composition containing calcium oxide or hydroxide is stored in contact with the air then the oxide gradually changes to carbonate over a period of time. This results in a decrease in the gettering capacity of the calcium compound. It is therefore necessary to activate the formed getter composition at a temperature sufficient to convert calcium hydroxide or calcium carbonate present to calcium oxide in order that the getter is active and has a high capacity for gettering water and CO₂. A getter formulation containing calcium carbonate may be heated for at least one hour at a temperature > 700 °C, for example > 740 °C, in order to achieve substantial conversion to calcium oxide. However these temperatures approach the decomposition temperature of PdO, especially if the temperature control during activation is insufficient to avoid hot spots. Therefore the combination of the known hydrogen getter PdO with a moisture getter based on CaO presents a problem in ensuring near-complete activation of the CaO without risking loss of PdO from the composition. If Pd is present in a particle which is activated or used in conditions which cause the Pd to sinter, the sintered Pd may reduce the effectiveness of the getter, for example by blocking pores. We have found that the hydrogen gettering performance of PdO decreases at temperatures exceeding about 80 °C so its inclusion in a getter composition intended for use at high temperatures is not beneficial. The avoidance of the use of Pd compounds in the getter composition of the invention also reduces the cost of manufacture. The getter composition of the invention is essentially free of palladium or a palladium compound, especially PdO. Essentially free of palladium means that the composition contains no palladium, save for an amount of Pd which has no material effect on the performance of the getter composition. Such an amount of palladium might, for example, be present as an impurity. A getter which is essentially free of palladium would be made by a process which does not use a palladium compound as a constituent of the getter composition, except where Pd is present as an impurity.

The getter composition may be activated at a temperature of at least 500 °C, for example at least 600 °C and especially at least 700 °C, for at least one hour, optionally for at least 2 hours.

In one form, the getter composition may comprise a material for absorbing or adsorbing organic compounds (an "organics sorbent"). The presence of organic compounds may cause a problem in sensitive electronic apparatus. Organic vapours may arise from polymeric materials used in the electronic equipment, for example in adhesives. Therefore the presence of a material for absorbing organic compounds in the getter composition may be beneficial. In one embodiment, therefore, the getter composition consists essentially of calcium oxide or a precursor thereof, copper oxide or a precursor thereof and optionally one or more components selected from the group consisting of a pore-forming compound, a binder, a material for absorbing or adsorbing organic compounds (i.e. an organics sorbent) and a lubricant.

Suitable organics sorbents include zeolites. Suitable zeolites may include zeolites having a high silica to alumina molar ratio. The silica to alumina molar ratio may be at least 10, or at least 15, for example at least 20. Examples of suitable high silica zeolites include those zeolites *BEA, ERI, EUO, FAU, FER, MAZ, MEI, MEL, MFI, MFS, MTT, MTW, NES, OFF, TON, CLO, MCM-22, NU-86 and NU-88 having silica to alumina molar ratios of at least 20, whether made by direct synthesis or by post-synthesis modification. The 3-letter designation codes are those set up by an IUPAC Commission on Zeolite Nomenclature. Full listings are available in the "Atlas of Zeolite Structure Types" published by Elsevier. Zeolites manufactured with a lower silica to alumina ratio may have their silica to alumina molar ratio increased post synthesis by de-alumination and/or by silylation. Thus zeolite Y, having a silica to alumina molar ratio of about 4-5, may have its silica to alumina molar ratio increased to above 20 by de-alumination, for example by acid extraction and/or steaming. De-aluminated zeolite Y having silica to alumina molar ratios up to about 120 are known and there are reports of materials with even higher silica to alumina ratios. All such materials are encompassed in this description. Zeolite beta (*BEA) is commonly synthesised with silica to alumina molar ratios above about 16, but much higher silica to alumina ratios can be obtained by de-alumination. Zeolite X and zeolite Y are examples of faujasite zeolites which may be suitable, optionally after dealumination. Mordenite-type zeolites may be used as the organic sorbent. Zeolites may be used in their hydrogen form or with a different cation, such as sodium or ammonium. Molecular sieves which may be useful organics sorbents in the getter composition include mesoporous silicas, such as MCM41, M41 or SBA 15 for example.

Suitable organics sorbents may be capable of being treated at a temperature of at least 500°C. The organic sorbent may be capable of withstanding a heat treatment at a temperature of at least 600 °C. In some embodiments an organic sorbent is used which is capable of withstanding a heat treatment at a temperature of at least 700 °C, for at least one hour, more preferably for at least 2 hours. That is, the organics sorbent, if present, may be capable of withstanding the activation conditions of the getter. The organics sorbent may be selected to sorb and retain organics at a temperature in the range from 0 to 250 °C.

When the getter composition comprises an organics sorbent in addition to the transition metal oxide and the alkaline earth metal oxide, the composition may contain from 1 - 75% (especially 5 - 60%, particularly 10 - 30% by weight) of the transition metal oxide. The composition may contain 10 - 98% by weight of the alkaline earth metal oxide, particularly 20 - 80%, especially 30 - 50% by weight of the alkaline earth metal oxide. The composition may contain from 1 to 75% by weight of the organics sorbent, especially 20 - 60%, particularly 30 - 50% by weight. The percentages are given as weight % of the active components, i.e. as a percentage of the total weight of organics sorbent plus the transition metal oxide plus the alkaline earth metal oxide.

The particle size of the components of the getter material may vary considerably. The selection of a suitable particle size and shape to form a solid shaped getter is within the experience of any skilled formulator. The average diameter of the primary particles will vary between 10 microns and 1000 microns, especially about 80 to 800 microns, and will normally be less than 500 microns. By "primary particles" we mean the particulate form of material before granulation, extrusion, tabletting etc. into larger shaped units. The particles may be ground, milled sieved etc. using known methods to select a suitable particle size and particle size distribution for the desired getter material. Particles of material for the getter composition may be mixed together in the form of a slurry.

The getter composition may be provided in the form of a powder. The getter particles may be provided in the form of granules, i.e. irregularly shaped particles or agglomerates of particles having a largest dimension of at most 5 mm. Granules may be formed by various methods known in the art. The getter particles may have a size between 100 µm (microns) and 5 mm (millimetres), if supplied in the form of powder or granules. Getter particles may have a size between 100 µm and 1 mm. When used in the form of powder or granules, the getter is usually contained within a capsule having a filter or frit to allow gases to contact the getter whilst preventing the getter particles from contaminating the enclosure which is being gettered. Getters in this form are known. Getter particles having a particle size less than 0.5 µm should be avoided so that they can be retained within the capsule by the frit.

The getter may be provided in the form of a shaped pellet or tablet. Such pellets or tablets are desirably non-friable and resistant to breakage. In this form, the getter dimensions may vary according to the application for which it is to be used, but typically the largest dimension is between about 2mm and 30 mm. The shape of the getter may be a circular, rectangular, triangular or other polygonal tablet, having a thickness of between about 0.5 and 20 mm. Other shapes designed to provide a relatively large surface for exposure to the atmosphere may also be used. A binder compound may be present in the getter to provide a strong tablet or extrudate. The binder is any suitable inorganic binder material. Suitable binders include non-porous silicas such as colloidal silica or fumed silica. The composition may contain up to 25 % by weight of the binder. Other compounds such as lubricants, colourants etc may also be present. Pelleting aids such as graphite or metal stearates (such as magnesium stearate) may be included in the powder mixture.

To assist with the extrusion tabletting or granulation process, or indeed to assist in the preparation of a paste which is subsequently dried and milled before tabletting, certain organic components may be added. These organic components can be readily removed during any calcination stage (as described above) leaving no residual organic species. For the tabletting process, convenient organic additives include polyvinyl alcohol or cellulose materials such as microcrystalline cellulose can be used.

Tabletting (or compaction) is a preferred method of preparing the final form of a getter according to the invention in the form of a shaped pellet or tablet. This is because it provides a higher density formed body than other methods of forming such as extrusion or granulation and can give products having a close dimensional tolerance. The higher density allows a higher mass loading of getter into a housing of a certain volume or alternatively allows the same mass of getter to be enclosed in a smaller volume: this is an important consideration for electronic and opto-electronic devices where overall physical dimensions are an important feature. The close dimensional tolerance allows preparation of getters which may fit tightly into a certain housing or retaining unit and, most importantly, allows very thin getters (for example about 0.5 mm thickness) to be prepared. Alternatively the getter may be made by other shaping techniques such as roll compacting or paste extrusion followed as necessary by calcination to remove any extrusion aids etc.

The getter composition may comprise a mixture of calcium oxide and a copper oxide, which may be formed into a shaped particle or granule so that the resulting particle contains both calcium oxide and copper oxide. When an organics sorbent is present in the getter composition, a shaped getter particle may contain calcium oxide and copper oxide and also an organics sorbent. Alternatively the getter composition may comprise particles of calcium oxide and particles of copper oxide. The getter composition may further comprise particles containing an organics sorbent, of the type previously described. The particles of calcium oxide, copper oxide and organics sorbent, may be formed into formed particles such as tablets or granules. A getter composition may therefore comprise formed particles of calcium oxide, and separate formed particles of copper oxide and optionally separate particles of organics sorbent. When separate formed particles are used in the method of the invention, they may be activated separately, optionally using different conditions for each type of formed particle, or they may be activated together.

The method of gettering hydrogen and moisture from a sealed enclosure at a temperature in the range 80-500 °C comprises the step of introducing into said enclosure a getter composition comprising at least one particle containing calcium oxide, at least one particle containing a copper oxide, and optionally at least one particle containing an organics sorbent. In this embodiment of the method, the at least one particle containing calcium oxide, and/or the at least one particle containing copper oxide, and optionally the at least one particle containing an organics sorbent may be present as formed particles, having a minimum dimension of at least 100 µm. Each of the formed particles may independently comprise a tablet, extrudate or granule.

The getter composition is suitable for gettering hydrogen from a sealed enclosure at temperatures between 80 °C and 500 °C, especially temperatures in the range 80 - 300 °C, for example at temperatures in the range 100 - 300 °C. The method of the invention may be a method of gettering hydrogen and moisture from an sealed enclosure at a temperature in the range 80 - 300 °C, particularly at temperatures above 100 °C, for example in the range 100 - 300 °C. The method of gettering may also comprise a method of gettering organic molecules from a sealed enclosure.

The getter composition is useful for gettering hydrogen and moisture. It may however, also be used for removing CO₂, and other reducing gases such as organics, methane, hydrocarbons and CO, from enclosures. In most commercial applications, the getter composition is placed in contact with a gaseous environment from which the hydrogen, moisture and/or organic compounds are to be gettered. The getter composition may, however, be used for gettering hydrogen and moisture from a liquid environment. For example the getter composition may be placed in contact with a liquid from which traces of hydrogen and water, if present, are intended to be removed. As an example of such a method, the getter composition may be used to getter hydrogen and moisture from a mineral oil. When used for such a purpose the getter may be provided in a form which maximises the contact between the liquid and the getter composition so that diffusion limitations which may restrict the rate of uptake of hydrogen or water may be minimised. The getter for use in such a method may be provided as particles in the form of a powder or granule contained within a filter, frit or gauze. The getter particles may have a size between 100 µm and 1 mm.

The invention will be further described in the following examples.

### Example 1

A batch of tablets comprising calcium hydroxide (80 wt%) and copper (II) oxide (20 wt%) was made. Calcium hydroxide and copper (II) oxide powders were pre-compressed under a force of approximately 20 tons, then sieved fractions of particle size 90 to 710 µm were mixed until fully dispersed, then pelleted into tablet form with dimensions of 5.4 mm diameter and 0.6 mm depth. The tablets appeared white with black 'speckles' throughout. The tablets were activated at 700 °C for one hour then tested for hydrogen uptake at various temperatures and CO uptake.

Hydrogen and carbon monoxide uptakes were measured using Micromeritics' ASAP 2010 and 2020 volumetric chemisorption analysers. Accurately weighed aliquots of approximately 0.5 to 1g of material were used. Activation of the sample was achieved by flowing helium through the sample at approximately 60 cm³ per minute and heating from ambient to the desired activation temperature at 10 °C per minute. Once the desired activation temperature was reached, helium was allowed to flow continuously through the sample for the desired activation time. At the end of this period the helium was switched off and the sample opened to vacuum whilst cooling to the desired analysis temperature and a pressure of less than 10 µmHg. When these conditions were met the sample was held under vacuum for a further 60 minutes. The uptake of pure gas was measured at 100, 150, 200, 300, 400, 500, 600, 700 and 760 mmHg using an equilibration time of 10 seconds to generate an equilibrium isotherm. Using the post activation sample weight the total gas uptake was reported as cm³/g at 760 mmHg.

Results are shown in Table 1. When the tablets were activated at 700°C for 1 hour, significant hydrogen uptake was recorded at 80°C with uptake increasing at higher temperatures reaching a value of 37.6cm³ g⁻¹ at 300°C. This equates to approximately 0.75 cm³ of H₂ per tablet.

The tablets of Example 1 were also tested for CO uptake using the method for H₂ uptake but using pure CO instead of H₂. The sample was activated at 750 °C for 4 hours in flowing helium then cooled to 180 °C and evacuated for one hour then tested for CO uptake from a flow of pure CO using the pressures and equilibration method described above. Using the post activation sample weight the total gas uptake was reported as 2.9 cm³/g at 760 mmHg.

### Comparative Example 2

A batch of tablets comprising calcium hydroxide (80 wt%) and palladium oxide (20 wt%) was made. Calcium hydroxide and palladium oxide powders were mixed together into a slurry with demineralised water, and dried for 24hours at room temperature. The material was milled, and then sieved fractions of particle size 90 to 710 µm were mixed until fully dispersed, then pelleted into tablet form with dimensions of 5.4 mm diameter and 0.6 mm depth. The tablets formed appeared grey throughout. The tablets were tested for hydrogen uptake as described for Example 1.

The hydrogen uptake results show that the performance of PdO for gettering hydrogen is significantly reduced at elevated temperatures after an activation step at 700 °C or above. This may be due to the decomposition of PdO at the activation temperatures to Pd and/or to the reduced stability of Pd hydrides at higher temperatures resulting in a decreased ability to sorb hydrogen.

**Table 1**

| Getter composition | Activation temperature /time | H₂ uptake temperature (°C) | H₂ uptake (cm³ g⁻¹) |
|---|---|---|---|
| Example 1 | 700°C/1 hour | 35 | 0 |
| Example 1 | 700°C/1 hour | 80 | 25.7 |
| Example 1 | 700°C / 1 hour | 180 | 26.8 |
| Example 1 | 700°C / 1 hour | 300 | 37.6 |
| Example 1 | 750°C / 4 hours | 180 | 28.2 |
| Comparative Example 2 | 700°C/1 hour | 35 | 33 |
| Comparative Example 2 | 700°C/1 hour | 80 | 39.3 |
| Comparative Example 2 | 700°C / 1 hour | 180 | 5.4 |
| Comparative Example 2 | 700°C / 1 hour | 300 | 4.9 |
| Comparative Example 2 | 750°C / 4 hours | 180 | 0.7 |
| Example 3 | 720°C / 4 hours | 180 | 2.2 |
| Example 4 | 720°C / 4 hours | 180 | 17.3 |

### Example 3

(a) Mix #1: Zeolite Y (CBV 901 from Zeolyst International) (177.78 g), colloidal silica (Ludox^{®} PX30 solution) (74.44 g) and demineralised water (300 mL) were mixed together gradually by hand and then in a speed mixer twice for 1 minute spins at 1800 rpm, each time scraping down the sides of the pot to ensure through mixing. The resulting slurry was poured on to a metal tray in a thin layer, and allowed to air dry in the laboratory for 24 hours, followed by drying in an oven for 24 hours at 25 °C followed by 24 hours at 50 °C. The dried and cooled slurry was scraped off the metal trays and gently milled down to allow sieving through a 710 µm sieve. The material was also sieved to remove any fines (< 90 µm) and the remaining sieve fraction kept for pelleting (90-710 µm).
(b) Mix #2: The same process as for Mix #1 was applied to an excess of calcium hydroxide (200.02 g) and demineralised water (300 mL) to produce a sieved material with the appropriate particle size for pelleting (90-710 µm).

110.0 g of Mix #1 and 110.0 g of Mix #2 tablet feeds were tumble-mixed by hand. CuO (24.4 g) was milled to less than 90 µm and added to the resulting Mix #1 + Mix#2 feed mixture. All three components were tumble mixed by hand to produce a mixed tablet feed. Magnesium stearate (1 % weight) was added to the feed as a lubricant for pelleting.

Tablets (5.4 x 0.6 mm) were made using a single-punch tablet press with the height tolerance set at +/- 0.05 mm. The finished tablets were gently brushed to remove any loose particles from the surface and analysed for Cu content using X-ray fluorescence spectroscopy (XRF), H₂ adsorption using chemisorption and gas adsorption analysis. The XRF results showed a copper content of only 6.56 % by weight, leading to a calculated copper oxide content of 8.21 % by weight. This was less than expected and indicated that some loss had occurred. This is confirmed by the H₂ adsorption result shown in Table 1.

### Example 4

Mix#1: Si-MCM-41 (87.27 g), colloidal silica (Ludox^{®} PX30) (41.74 g) and demineralised water (400 mL) were mixed together gradually by hand and then mixed in a large speed mixer twice with 30 second spins at 1500 rpm, each time scraping down the sides of the pot to ensure through mixing. The resulting slurry was poured on to a metal tray in a thin layer, labelled and allowed to air dry in the laboratory for 24 hours, followed by drying in an oven for 24 hours at 25 °C followed by 24 hours at 50 °C. The dried and cooled slurry was scraped off the metal trays and gently milled down to allow sieving (through a 710 µm sieve). The material was also sieved to remove any fines (< 90 µm) and the remaining sieve fraction kept for pelleting (90-710 µm).

Mix # 2: The above process was applied to Ca(OH)₂ (200.24 g), CuO (100.04 g) and demineralised water (300 mL) to produce a sieved material (90-710 µm). The copper oxide was milled and sieved before mixing with the Ca(OH)₂.

Mix #1 (80.11 g) and Mix#2 (120.83 g) were tumble mixed and magnesium stearate (1 % weight) was added to produce a feed for pelleting. Tablets were made using the tabletting procedure described in Example 3. XRF showed a copper content of 10.91% by weight, leading to a calculated copper oxide content of 13.66% by weight.

### Example 5: test for organics and water uptake

Individual getter tablets (each 1 - 2 g in weight) were placed into pre-weighed sample vials and activated in a furnace using the following temperature profile: heat to 120 °C and hold for 2 hours, then heat to 700 °C and hold for 8 hours. All heating ramps were 40 minutes in duration. The activated tablets were cooled in a desiccator under vacuum and the weight of the activated material was recorded.

The uptake of organics was measured using a Parr^{®} bomb pressure-resistant vessel. Preparation of the Parr bomb was carried out inside a nitrogen-blanketed glove-box. 0.5 g of organic solvent was placed into the PTFE cup of the Parr bomb. The pre-activated tablet, inside a glass vial (with the lid removed), was placed into the PTFE cup on top of the solvent. The Parr bomb was then sealed and tightened. The Parr bomb was heated in an oven for 18 hours at 220 °C (for cyclohexane) or 250 °C (for 1-butanol or water). The oven was left to cool for 2.5 hours before the door was opened and the Parr bomb was removed. The weight of the sample was taken and the samples were sealed in order to minimise further adsorption or desorption from the atmosphere. The % weight gain was calculated. Results are shown in Table 2. The Comparison sample contained a combination of a low-silica FAU zeolite and a high-silica FAU zeolite, with no CuO or Ca(OH)₂.

**Table 2**

| Getter sample | % Weight gain in: | | |
|---|---|---|---|
| | Water | Cyclohexane | 1-butanol |
| Example 3 | 12.2 | 15.4 | not measured |
| Example 4 | 13.2 | 16.0 | 25.6 |
| Comparison | 9.9 | 13.2 | 12.5 |

### Example 6: Desorption of cyclohexane and water

The tablet samples discharged from the Parr bomb after the cyclohexane and water absorption measurements were analysed using a dynamic vapour sorption analyser (DVS model 080711-01 from Surface Measurement Systems Ltd), to evaluate desorption of the sorbed water and cyclohexane from the tablets. The weight of the sample was monitored over time as a heating profile was applied to the sample. The temperature profile applied included holding at each of 50, 100, 150, 200 and 250 °C for two hours, with 20 minute ramps between temperatures. The initial ramp from room temperature to 50 °C was also 20 minutes. The difference between the weight of the tablet after activation (i.e. before placing into the Parr bomb) and its weight following desorption at a particular temperature, measured using the DVS microbalance, was used to calculate, as a percentage, the amount of sorbed material

(organic or water) retained at each temperature. This value is related to the absorption capacity of the tablet at each temperature and is shown in Table 3.

**Table 3**

| | % weight change (between activated sample and sample following desorption) | | | | |
|---|---|---|---|---|---|
| | Cyclohexane | | | Water | |
| T up to (°C) | Example 3 | Example 4 | Comparison | Example 3 | Comparison |
| 20 | 15.4 | 16.0 | 13.2 | 12.2 | 9.9 |
| 50 | 10.9 | 7.9 | 9.3 | 10.8 | 9.2 |
| 100 | 9.7 | 6.9 | 4.9 | 9.5 | 5.8 |
| 150 | 9.2 | 6.2 | 3.0 | 8.8 | 4.0 |
| 200 | 9.1 | 5.7 | 2.0 | 8.4 | 2.7 |
| 250 | 9.1 | 6.1 | 1.0 | 8.0 | 1.1 |

## Claims

1. A method of gettering hydrogen and moisture from a sealed enclosure at a temperature in the range 80-500 °C comprising the step of introducing into said enclosure a getter composition comprising calcium oxide and copper oxide, and wherein the getter composition is essentially free of palladium or a palladium compound.

2. A method according to claim 1 wherein said calcium oxide and copper oxide are present as a mixture.

3. A method according to claim 1 or claim 2 wherein the getter composition further comprises an organics sorbent.

4. A method according to claim 3, wherein said organics sorbent is selected from the group consisting of a zeolite having a silica : alumina ratio > 10 and a mesoporous silica.

5. A method according to any one of claims 1 to 4 wherein the getter composition consists essentially of particles of calcium oxide, particles of copper oxide and optionally one or more components selected from the group consisting of a pore-forming compound, a binder, an organics sorbent and a lubricant.

6. A method according to any one of claims 1 to 5 wherein the getter composition is in the form of a shaped pellet, tablet or granule.

7. A method according to claim 1, wherein the hydrogen and moisture are present in a gas or a liquid.

## Patentansprüche

1. Verfahren zum Gettern von Wasserstoff und Feuchtigkeit aus einem abgedichteten Gehäuse bei einer Temperatur im Bereich von 80-500 °C, umfassend den Schritt eines Einbringens einer Getterzusammensetzung, umfassend Calciumoxid und Kupferoxid, in das Gehäuse, und wobei die Getterzusammensetzung im Wesentlichen frei von Palladium oder einer Palladiumverbindung ist.

2. Verfahren nach Anspruch 1, wobei das Calciumoxid und das Kupferoxid als ein Gemisch vorliegen.

3. Verfahren nach Anspruch 1 oder 2, wobei die Getterzusammensetzung weiterhin ein Sorptionsmittel für organische Substanzen umfasst.

4. Verfahren nach Anspruch 3, wobei das Sorptionsmittel für organische Substanzen aus der Gruppe bestehend aus einem Zeolith mit einem Siliciumdioxid:Aluminiumoxid-Verhältnis > 10 und einem mesoporösen Siliciumdioxid ausgewählt ist.

5. Verfahren nach einem der Ansprüche 1 bis 4, wobei die Getterzusammensetzung im Wesentlichen aus Calciumoxidteilchen, Kupferoxidteilchen und optional einer oder mehreren Komponenten, die aus der Gruppe bestehend aus einer porenbildenden Verbindung, einem Bindemittel, einem Sorptionsmittel für organische Substanzen und einem Gleitmittel ausgewählt sind, besteht.

6. Verfahren nach einem der Ansprüche 1 bis 5, wobei die Getterzusammensetzung in der Form eines geformten Pellets, einer geformten Tablette oder einem geformten Granulat ist.

7. Verfahren nach Anspruch 1, wobei der Wasserstoff und die Feuchtigkeit in einem Gas oder einer Flüssigkeit vorliegen.

## Revendications

1. Procédé de capture d'hydrogène et d'humidité d'une enceinte hermétiquement fermée à une température dans la plage de 80-500°C comprenant l'étape d'introduction dans ladite enceinte d'une composition de capture comprenant de l'oxyde de calcium et de l'oxyde de cuivre et la composition de capture étant essentiellement exempte de palladium ou de composé à base de palladium.

2. Procédé selon la revendication 1, ledit oxyde de calcium et ledit oxyde de cuivre étant présents sous forme de mélange.

3. Procédé selon la revendication 1 ou la revendication 2, la composition de capture comprenant en outre un sorbant de matières organiques.

4. Procédé selon la revendication 3, ledit sorbant de matières organiques étant choisi dans le groupe constitué par une zéolithe présentant un rapport silice:aluminine > 10 et une silice mésoporeuse.

5. Procédé selon l'une quelconque des revendications 1 à 4, la composition de capture étant essentiellement constituée de particules d'oxyde de calcium, de particules d'oxyde de cuivre et éventuellement d'un ou de plusieurs constituants choisis dans le groupe constitué par un composé porogène, un liant, un sorbant de matières organiques et un lubrifiant.

6. Procédé selon l'une quelconque des revendications 1 à 5, la composition de capture étant sous forme d'un pellet, comprimé ou granule façonné.

7. Procédé selon la revendication 1, l'hydrogène et l'humidité étant présents dans un gaz ou dans un liquide.
